(19) Europäisches Patentamt
European Patent Office
Office européen des brevets

(11) **EP 3 647 812 A1**

(12) **EUROPEAN PATENT APPLICATION**
published in accordance with Art. 153(4) EPC

(43) Date of publication:
06.05.2020 Bulletin 2020/19

(21) Application number: 18824696.1

(22) Date of filing: 25.06.2018

(51) Int Cl.:
*G01S 7/489* (2006.01)    *G01S 7/487* (2006.01)

(86) International application number:
PCT/JP2018/024052

(87) International publication number:
WO 2019/004144 (03.01.2019 Gazette 2019/01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 27.06.2017 JP 2017124933

(71) Applicant: Pioneer Corporation
Tokyo 113-0021 (JP)

(72) Inventors:
• **HAYASHI, Yukio**
  **Kawagoe-shi**
  **Saitama 350-8555 (JP)**
• **ABE, Yoshinori**
  **Kawagoe-shi**
  **Saitama 350-8555 (JP)**

(74) Representative: **Viering, Jentschura & Partner mbB**
**Patent- und Rechtsanwälte**
**Am Brauhaus 8**
**01099 Dresden (DE)**

(54) **RECEIVING DEVICE, CONTROL METHOD, PROGRAM AND STORAGE MEDIUM**

(57)     A lidar 1 is provided with an APD 41 and a DSP 16. The APD 41 receives a return light Lr that is an outgoing light Lo radiated by a scanner 55 and thereafter reflected by an object. The DSP 16 includes a shot noise estimation unit 77 and a voltage control unit 78. The shot noise estimation unit 77 estimates, on the basis of the output signal from the APD 41, information associated with background light amount that is the sun light reflected by the object and thereafter received by the APD 41. The voltage control unit 78 determines, on the basis of the information associated with the estimated background light amount, the voltage to be applied to the APD 41 in order to control the gain M of the APD 41.

FIG. 10

EP 3 647 812 A1

**Description**

TECHNICAL FIELD

The present invention relates to a technology for measuring a distance by use of an electromagnetic ray such as a laser beam.

BACKGROUND TECHNIQUE

Conventionally, as a ranging device by use of light, there is a widely-used device configured to emit a pulsed light to a target object of measurement and to measure the distance to the target object based on the timing of receiving the pulsed light reflected at the target object. For such a ranging device, there is a case that the strong sun light that is a disturbance in measurement is reflected at the target object thereby to enter its light receiving element. In case of a long-distance measurement, since the pulsed light for ranging which enters the light receiving element after the reflection at target object becomes very weak, there unfortunately occurs the large variance of the measurement values and inability of the measurement. Regarding these issues, Patent Reference-1 discloses such a ranging device equipped with a reverse voltage circuit which applies a bias voltage to an APD (Avalanche Photodiode) and an operation control unit which controls the output voltage of the reverse voltage circuit so as to maximize the signal-to-noise ratio (SNR) of the output of the APD in accordance with the disturbance light such as a sun light.

Patent Reference-1: Japanese Patent Application Laid-open under No. 2008-286669

DISCLOSURE OF INVENTION

PROBLEM TO BE SOLVED BY THE INVENTION

The ranging device according to Patent Reference-1 needs not only the APD but also an illuminometer to estimate the disturbance light, leading to such an issue that the manufacturing cost thereof increases.

The above is an example of the problem to be solved by the present invention. An object of the present invention is to provide a receiving device capable of controlling the light receiving unit so as to obtain an optimal SNR in consideration of the influence by the disturbance light.

MEANS FOR SOLVING THE PROBLEM

One invention is a receiving device including: a receiving unit which receives a reflected electromagnetic ray that is an electromagnetic ray reflected by an object, the electromagnetic ray being radiated from an irradiation unit; an estimation unit configured to estimate a background light amount based on an output signal from the receiving unit; and a control unit configured to control the receiving unit based on information associated with the estimated background light amount.

Another invention is a control method executed by a receiving device, the receiving device including a receiving unit which receives a reflected electromagnetic ray that is an electromagnetic ray reflected by an object, the electromagnetic ray being radiated from an irradiation unit, the control method including: an estimation process to estimate a background light amount based on an output signal from the receiving unit; and a control process to control the receiving unit based on information associated with the estimated background light amount.

Still another invention is a program executed by a computer of a receiving device, the receiving device including a receiving unit which receives a reflected electromagnetic ray that is an electromagnetic ray reflected by an object, the electromagnetic ray being radiated from an irradiation unit, the program making the computer function as : an estimation unit configured to estimate a background light amount based on an output signal from the receiving unit; and a control unit configured to control the receiving unit based on information associated with the estimated background light amount.

BRIEF DESCRIPTION OF THE DRAWINGS

FIG. 1 illustrates an overall configuration of a lidar according to an embodiment.
FIGS. 2A and 2B illustrate configurations of a transmitter and a receiver.
FIG. 3 illustrates a configuration of a scan optical component.
FIG. 4 illustrates a register configuration example of control signals generated by a synchronization controller.
FIG. 5 illustrates the time variations of the control signals generated by a synchronization controller.

FIGS. 6A to 6F illustrate graphs indicative of a relation between the output signal of an ADC and its gate.

FIGS. 7A to 7D illustrate waveforms of a pulse trigger signal, a receiving segment signal and an AD gate signal in cases that a pre-trigger period is provided.

FIG. 8A illustrates time variations of the pulse trains of a rotary encoder.

FIG. 8B illustrates a temporal relation between the encoder pulses and segment slots at steady state.

FIGS. 9A and 9B schematically illustrate the arrangement of a dark reference reflective member.

FIG. 10 is a block diagram of the signal processing executed by a DSP according to the first embodiment.

FIG. 11 is a block diagram of the signal processing executed by a shot noise estimation unit.

FIGS. 12A and 12B illustrate relations between the SNR and the gain of an APD in cases that the receiving background light amount is different.

FIGS. 13A and 13B illustrate the relations between the receiving background light amount and the voltage to be applied to the APD.

FIG. 14 is a block diagram of the signal processing executed by the DSP according to the second embodiment.

FIG. 15 is a block diagram of the signal processing executed by a DC estimation unit.

## DETAILED DESCRIPTION OF THE PREFERRED EMBODIMENTS

According to a preferable embodiment of the present invention, there is provided a receiving device including: a receiving unit which receives a reflected electromagnetic ray that is an electromagnetic ray reflected by an object, the electromagnetic ray being radiated from an irradiation unit; an estimation unit configured to estimate a background light amount based on an output signal from the receiving unit; and a control unit configured to control the receiving unit based on information associated with the estimated background light amount. The term "background light amount" which the estimation unit estimates herein includes not only what directly indicates the amount of the background light but also what the amount of the background light can be indirectly derived from. The term "background light" herein includes a sun light and lights from peripheral street lamps and other peripheral lamps which are received by the receiving unit after the reflection at the object and the like. Furthermore, the term "background light" also includes, among the electromagnetic rays which the receiving unit receives, electromagnetic rays other than the reflected electromagnetic rays which are radiated by the irradiation unit and thereafter reflected at the object. According to this mode, the receiving device can suitably control the receiving unit to obtain an optimal SNR in accordance with the background light amount which the receiving unit receives.

In one mode of the above receiving device, the receiving unit includes a photodiode, and wherein the control unit controls a gain of the photodiode. According to this mode, the receiving device controls the gain of the photodiode in accordance with the background light amount so as to maximize the SNR, thereby raising the light receiving sensitivity of the photodiode.

In another mode of the above receiving device, the control unit determines a voltage to be applied to the receiving unit by referring to a table for determining, from the information associated with the background light amount, the voltage which makes a signal-to-noise ratio of the receiving unit a predetermined value. According to this mode, the receiving device can determine the voltage to be applied to the receiving unit so as to achieve a high degree of the SNR.

In still another mode of the above receiving device, the table includes : a first table for determining, from the information associated with the background light amount, a gain of the receiving unit which makes the signal-to-noise ratio the predetermined value; and a second table for determining the voltage to be applied to the receiving unit to obtain the gain of the receiving unit. According to this mode, the receiving device determines the gain of the receiving unit which maximizes the signal-to-noise ratio from the information associated with the estimated background light amount and thereafter suitably determines the voltage to be applied to the receiving unit to obtain the above gain.

In still another mode of the above receiving device, the estimation unit estimates the background light amount based on the output signal from the receiving unit, the output signal being generated before a time period when the reflected electromagnetic ray is received. According to this mode, the receiving device can suitably estimate the background light amount based on the output signal from the receiving unit which is not affected by the reflected electromagnetic waves.

In still another mode of the above receiving device, the estimation unit estimates the background light amount based on the output signal outputted at a first timing from the receiving unit and the output signal outputted at a second timing from the receiving unit. According to this mode, the receiving device can accurately estimate the background light amount based on the output signals obtained from the receiving unit at different timings.

In still another mode of the above receiving device, the estimation unit estimates the background light amount with respect to each segment period in which the output signal corresponding to each radiating direction by the irradiation unit is obtained from the receiving unit, and wherein the control unit controls a gain of the receiving unit with respect to each segment period. According to this mode, the receiving device estimates the background light amount with respect to each segment period and suitably controls the receiving unit so that the SNR with resect to each segment is maximized.

In still another mode of the above receiving device, the estimation unit estimates, as the information associated with the background light amount, an increase in a shot noise generated due to the background light amount, and wherein the control unit controls the receiving unit based on the increase in the shot noise. According to this mode, the receiving device can suitably control the receiving light in consideration of the background light amount.

In still another mode of the above receiving device, the estimate unit estimates an increase in a direct current component generated due to the background light amount, and wherein the control unit controls the receiving unit based on: the increase in the direct current component; and a gain of the receiving unit at a time when the output signal used for the estimation of the increase in the direct current component is outputted. Even according to this mode, the receiving device can suitably control the receiving unit in consideration of the background light amount.

According to another preferable embodiment of the present invention, there is provided a control method executed by a receiving device, the receiving device including a receiving unit which receives a reflected electromagnetic ray that is an electromagnetic ray reflected by an object, the electromagnetic ray being radiated from an irradiation unit, the control method including: estimation process to estimate a background light amount based on an output signal from the receiving unit; and a control process to control the receiving unit based on information associated with the estimated background light amount. By executing the control method, the receiving device can suitably control the receiving unit to obtain an optimal SNR in accordance with the background light amount which the receiving unit receives.

According to still another preferable embodiment of the present invention, there is provided a program executed by a computer of a receiving device, the receiving device including a receiving unit which receives a reflected electromagnetic ray that is an electromagnetic ray reflected by an object, the electromagnetic ray being radiated from an irradiation unit, the program making the computer function as : an estimation unit configured to estimate a background light amount based on an output signal from the receiving unit; and a control unit configured to control the receiving unit based on information associated with the estimated background light amount. By executing the program, the computer can suitably control the receiving unit to obtain an optimal SNR in accordance with the background light amount which the receiving unit receives. Preferably, the program can be treated in a state that it is stored in a storage medium.

EMBODIMENT

Now, preferred embodiments of the present invention will be described below with reference to the attached drawings.

<Basic Explanation>

First, a description will be given of the basic configuration of a lidar according to the embodiment.

(1) Entire Configuration

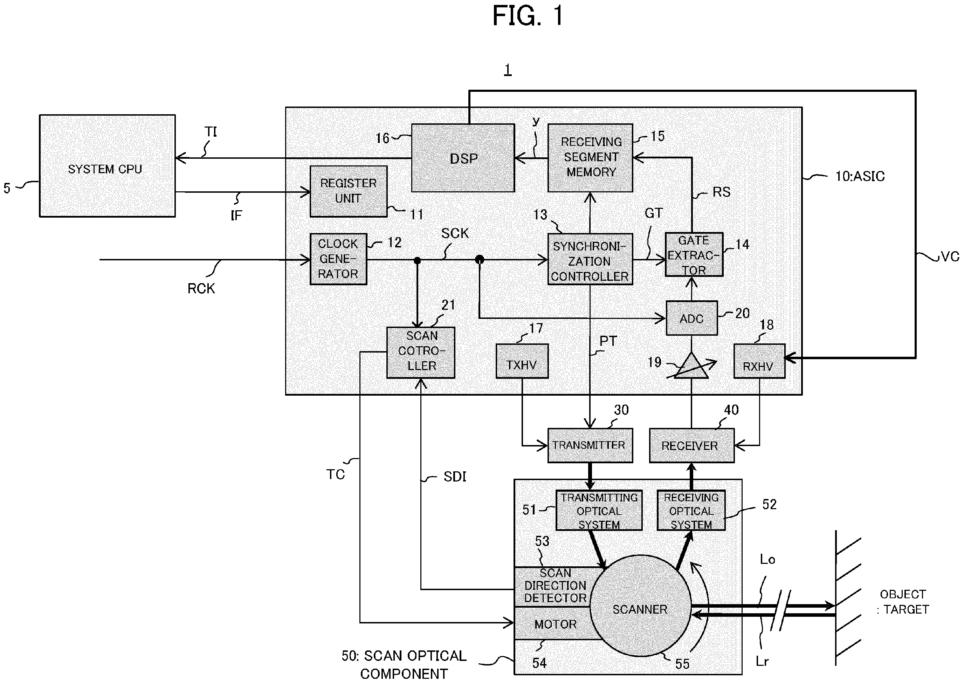

FIG. 1 illustrates an entire configuration of a lidar 1 according to the embodiment. The lidar 1 scans peripheral space by properly controlling the outgoing direction (hereinafter, referred to as "scan direction") of pulsed light beams repeatedly emitted and monitors the return light thereof. Thereby, the lidar 1 recognizes information (e.g., the distance, the existence probability or the reflection rate) associated with an object situated in the vicinity. Specifically, the lidar 1 emits a pulsed light beam (hereinafter, referred to as "outgoing light Lo") and receives the pulsed light beam (hereinafter, referred to as "return light Lr") reflected by an external object (target) to thereby generate information associated with the object. The lidar 1 is an example of the "receiving device" according to the present invention.

As illustrated in FIG. 1, the lidar 1 mainly includes a system CPU 5, an ASIC 10, a transmitter 30, a receiver 40 and a scan optical component 50. The transmitter 30 repeatedly outputs a pulsed laser light with the width of approximately 5 nsec in response to the pulse trigger signal "PT" supplied from the ASIC 10. The pulsed laser light outputted by the transmitter 30 is supplied to the scan optical component 50.

The scan optical component 50 emits (radiates) the pulsed laser light outputted by the transmitter 30 to a proper direction while collecting the return light Lr and supplying the return light Lr to the receiver 40, wherein the return light Lr is returned after the reflection or diffusion at an object in a space . According to the embodiment, at the scan optical component, there is provided a dark reference reflective member 7 which absorbs the outgoing light Lo emitted in a prescribed scan direction. The scan optical component 50 is an example of the "irradiation unit" according to the present invention. The receiver 40 supplies the ASIC 10 with a signal in accordance with the intensity of the return light Lr. The receiver 40 is an example of the "receiving unit" according to the present invention.

The ASIC 10 estimates and outputs parameter(s) (e.g., distance) associated with an object situated in the scan space by analyzing the output signal of the receiver 40. The ASIC 10 also controls the scan optical component 50 to provide a proper scan. Furthermore, the ASIC 10 supplies the transmitter 30 and the receiver 40 with high voltages necessary for them, respectively.

The system CPU 5 at least performs an initial setup, surveillance, and/or control of the ASIC 10 through a communication interface. Other functions thereof depend on the application. For the simplest lidar, the system CPU 5 only converts the target information "TI" outputted by the ASIC 10 into a proper formats and outputs it. For example, after converting the target information TI into point cloud formats with high flexibility, the system CPU 5 outputs it through a USB interface.

(2) Transmitter

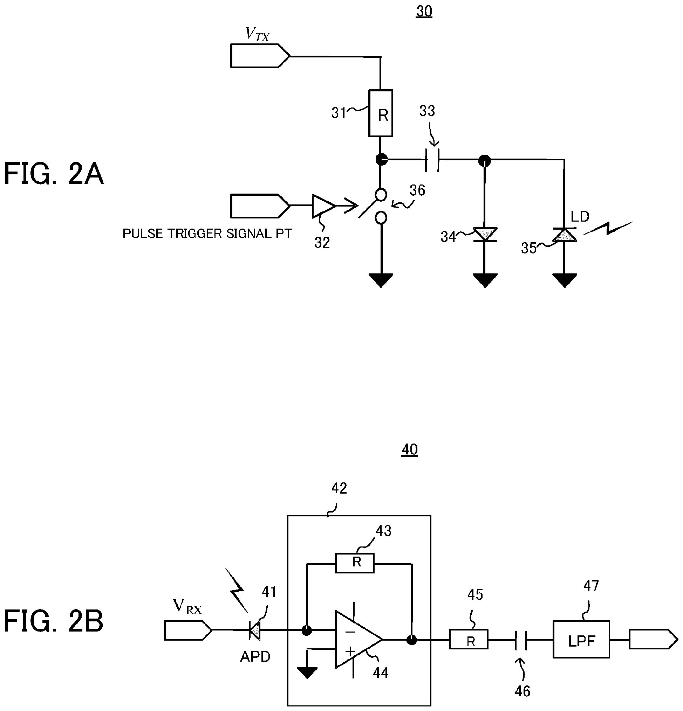

The transmitter 30 repeatedly outputs a pulsed laser light with the width of approximately 5 nsec in response to the pulse trigger signal PT supplied from the ASIC 10. FIG. 2A illustrates the configuration of the transmitter 30. The transmitter 30 includes a charging resistor 31, a driver circuit 32, a capacitor 33, a charging diode 34, a laser diode (LD) 35 and a CMOS switch 36.
The pulse trigger signal PT inputted from the ASIC 10 drives the CMOS switch 36 via the driver circuit 32. The driver circuit 32 is provided for prompt driving of the COMS switch 36. The COMS switch is open during a deassertion period of the pulse trigger signal PT and the capacitor 33 in the transmitter 30 is charged with the high voltage $V_{TX}$ supplied from the ASIC 10. In contrast, during an assertion period of the pulse trigger signal PT, the CMOS switch 36 is close and the charge stored on the capacitor 33 is discharged through the LD 35. As a result, a pulsed laser light is outputted from the LD 35.

(3) Receiver

The receiver 40 outputs a voltage signal proportional to the intensity of the return light Lr returned from an object. Generally, since light detecting elements such as an APD output current, the receiver 40 converts (i.e., performs I/V conversion) the current into the voltage to output it. FIG. 2B illustrates a configuration of the receiver 40. The receiver 40 includes an APD (Avalanche Photodiode) 41, an I/V converter 42, a resistor 45, a capacitor 46 and a low pass filter (LPF) 47. The I/V converter 42 includes a feedback resistor 43 and an operational amplifier 44.
According to the embodiment, the APD 41 is used as a light detecting element. The high voltage $V_{RX}$ supplied from the ASIC 10 is applied to the APD 41 as a reverse bias and the detection current proportional to the return light Lr returned from an object passes through the APD 41. A high gain of the APD 41 can be obtained by applying a revers bias which approximates the breakdown voltage of the APD 41, which enables the APD 41 to detect even a weak return light Lr. Hereinafter, the gain of the APD 41 is referred to as "gain M". The LPF 47 situated at the last position is provided for restricting the bandwidth of the signal prior to sampling by the ADC 20 in the ASIC 10. According to the embodiment, the sampling frequency of the ADC 20 is 512 MHz and the cutoff frequency of the LPF 47 is approximately 250 MHz.

(4) Scan Optical Component

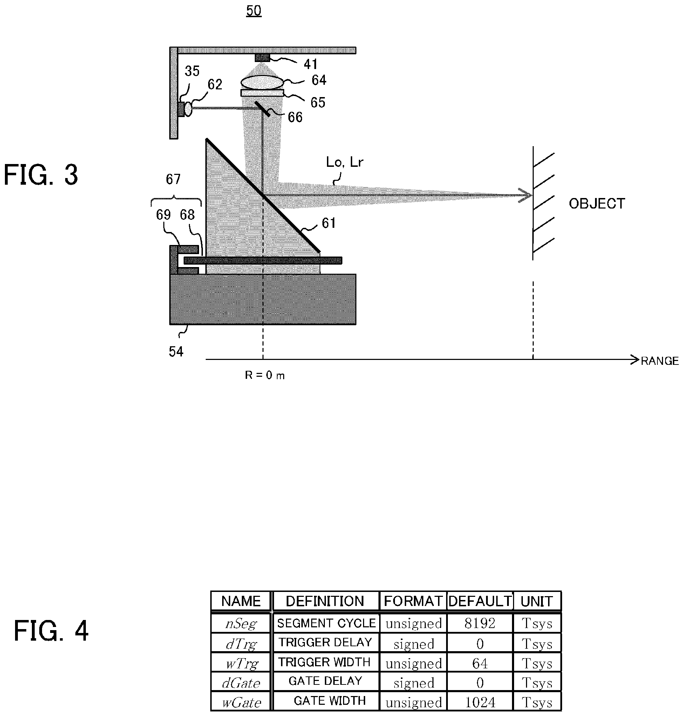

The scan optical component 50 emits the pulsed laser light inputted from the transmitter 30 as the outgoing light Lo to a proper direction while collecting the return light Lr and supplying the return light Lr to the receiver 40, wherein the return light Lr is the outgoing light Lo returned after the reflection or diffusion at an object in a space. FIG. 3 illustrates a configuration example of the scan optical component 50. The scan optical component 50 includes a revolving mirror 61, a collimator lens 62, a collecting lens 64, an optical filter 65, a coaxial mirror 66 and a rotary encoder 67.
The pulsed laser light outputted from the LD 35 of the transmitter 30 enters the collimator lens 62. The collimator lens 62 collimates the laser light within a proper divergent angle (generally, approximately within the range of 0 to 1 degree) . The light emitted from the collimator lens 62 is reflected by the small coaxial mirror 66 towards the downward direction to thereby enter the rotational axis (center) of the revolving mirror 61. The revolving mirror 61 reflects the laser light which is incident from the upward direction to the horizontal direction to thereby emit the laser light into a scan space. The revolving mirror 61 is provided at the revolving part of the motor 54 and the laser light reflected by the revolving mirror 61 scans, as the outgoing light Lo, a horizontal plane along with the rotation of the motor 54.
The return light Lr, which gets back to the lidar 1 through the reflection or diffusion at the object situated in the scan space, is reflected by the revolving mirror 61 towards the upward direction to enter the optical filter 65. Together with the return light Lr, the background light, which is generated through the irradiation of the object by the sun, also enters the optical filter 65. The optical filter 65 is provided to selectively eliminate such background light. Specifically, the optical filter 65 selectively passes components having a wavelength within the range of the wavelength (905 nm according to the embodiment) of the outgoing light Lo plus or minus 10 nm. In such a case that the passband width of the optical filter 65 is large, a large amount of background light enters the following receiver 40. As a result, unfortunately, a large DC current component appears in the output of the APD 41 of the receiver 40 and the shot noise (background light shot noise) generated due to the DC component degrades the signal-to-noise ratio. On the other hand, if the passband width was too narrow, the outgoing light Lo itself couldbe also suppressed, which leads to undesirable result.

The collecting lens 64 collects the light which passes through the optical filter 65 and then supplies it to the APD 41 of the receiver 40.

The rotary encoder 67 is provided on the motor 54 to detect the scan direction. The rotary encoder 67 includes a spinning disk 68 provided on the revolving part of the motor and a code detector 69 mounted on the base of the motor. Slits which illustrate rotational angles of the motor 54 are marked on the outer circumference of the spinning disk 68. The code detector 69 reads the slits and outputs the result. Specifications of the rotary encoder 67 and the motor control based on the output thereof will be explained later.

According to the above configuration, the collimator lens 62 constitutes the transmitting optical system 51 in FIG. 1, the revolving mirror 61 constitutes the scanner 55 in FIG.1, the optical filter 65 and the collecting lens 64 constitute the receiving optical system 52 in FIG. 1 and the rotary encoder 67 constitutes the scan direction detector 53 in FIG. 1.

(5) ASIC

The ASIC 10 controls the timing of the pulsed laser light and performs the AD conversion of the APD output signal. Through a proper signal processing on the output of the AD conversion, the ASIC 10 estimates a parameter (e.g., distance and return light intensity) relating to the object and outputs the estimate result to an external device. As illustrated in FIG. 1, the ASIC 10 includes a register unit 11, a clock generator 12, a synchronization controller 13, a gate extractor 14, a receiving segment memory 15, a DSP 16, a transmitter high voltage generator (TXHV) 17, a receiver high voltage generator (RXHV) 18, a pre-amplifier 19 and an AD converter 20 and a scan controller 21.

On the register unit 11, there are provided communication registers capable of communicating with the system CPU 5 that is an external processor. The registers provided on the register unit 11 fall roughly into two types of registers, a R register which can only be referred to by an external and a W register which can be configured by an external. The R register mainly stores internal status values of the ASIC 10, and the system CPU 5 can monitor the internal status values of the ASIC 10 by reading the internal status values through a communication interface. In contrast, the w register stores various parameter values to be referred to in the ASIC 10. These parameter values can be determined by the system CPU 5 through the communication interface. It is noted that the communication registers may be implemented as a flip-flop circuit or may be implemented as a RAM.

The clock generator 12 generates a system clock "SCK" to supply it to each block in the ASIC 10. Most blocks in the ASIC 10 act in synchronization with the system clock SCK. The frequency of the system clock SCK according to the embodiment is 512 MHz. The system clock SCK is generated in a PLL (Phase Locked Loop) so as to synchronize with a reference clock "RCK" inputted from an external. Normally, a crystal oscillator is used as a generator of the reference clock RCK.

The TXHV 17 generates the DC (direct-current) high voltage (approximately 100 V) which is necessary for the transmitter 30. The high voltage is generated through a DCDC converter circuit which raises the low voltage (approximately 5V to 15V).

On the basis of a control signal "VC" which relates to a voltage to be applied to the receiver 40 and which is supplied from the DSP 16, the RXHV 18 generates the DC (direct-current) high voltage (approximately 100 V) which is necessary for the receiver 40. The high voltage is generated through a DCDC converter circuit which raises the low voltage (approximately within the range of 5V to 15V).

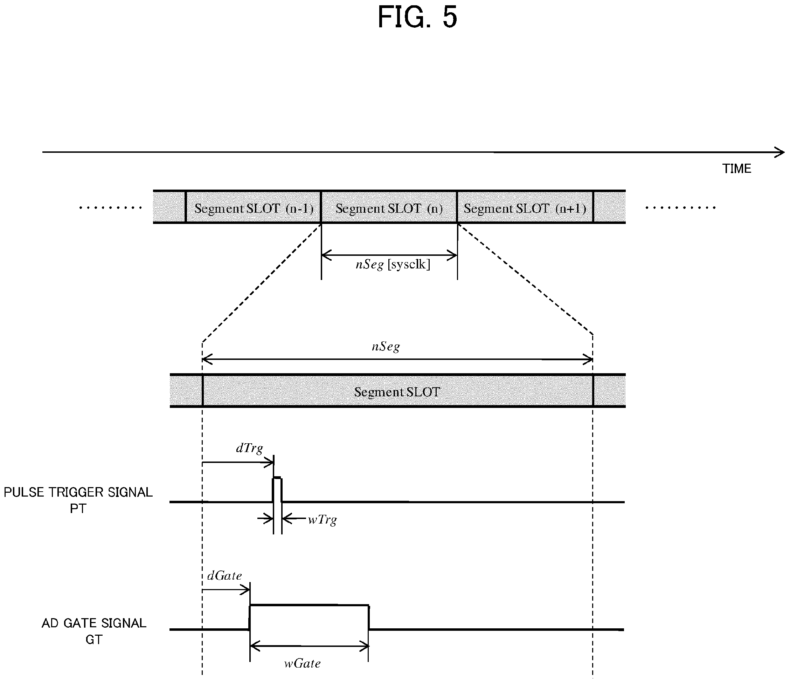

The synchronization controller 13 generates and outputs various control signals. The synchronization controller 13 according to the embodiment outputs two control signals, i.e., the pulse trigger signal PT and an AD gate signal "GT". FIG. 4 illustrates a configuration example of these control signals and FIG. 5 illustrates the temporal relation between the two control signals. As illustrated in FIG. 5, these control signals are generated in synchronization with evenly-divided time sections (segment slots) . The time length (segment cycle) of each segment slot can be configured by use of "nSeg". Hereinafter, "nSeg = 8192" is assumed in the embodiment if there is no mention of the segment cycle.

The pulse trigger signal PT is supplied to the transmitter 30 which is provided outside the ASIC 10. The transmitter 30 outputs the pulsed laser light in accordance with the pulse trigger signal PT. For the pulse trigger signal PT, a time delay "dTrg" from the start point of the segment slot and a pulse width "wTrg" can be configured. It is noted that the transmitter 30 does not react if the pulse width wTrg is too narrow. Thus, the pulse width wTrg may be determined in consideration of the specifications of the transmitter 30 regarding the trigger response.

The AD gate signal GT is supplied to the gate extractor 14. As is mentioned below, the gate extractor 14 extracts each section (period), in which the AD gate signal GT is asserted, from the ADC output signal inputted from the ADC 20 and then stores it on the receiving segment memory 15. For the AD gate signal GT, the delay time "dGate" from the start point of the segment slot and the gate width "wGate" can be configured.

The pre-amplifier 19 amplifies the analog voltage signal inputted from the receiver 40 which is provided outside the ASIC 10 and supplies it to the following ADC 20. It is noted that the gain of the voltage of the pre-amplifier 19 can be configured through the w register.

The ADC 20 converts the output signal of the pre-amplifier 19 into a digital signal through the AD conversion.

According to the embodiment, the system clock SCK is used as the sampling clock of the ADC 20 and therefore the input signal of the ADC 20 is sampled at 512 MHz.

The gate extractor 14 extracts, from the ADC output signal inputted from the ADC 20, only each sectional signal corresponding to the assertion period of the AD gate signal GT and stores it on the receiving segment memory 15. Each sectional signal extracted by the gate extractor 14 is referred to as "receiving segment signal RS". In other words, the receiving segment signal RS is a real vector whose vector length is equal to the gate width wGate.

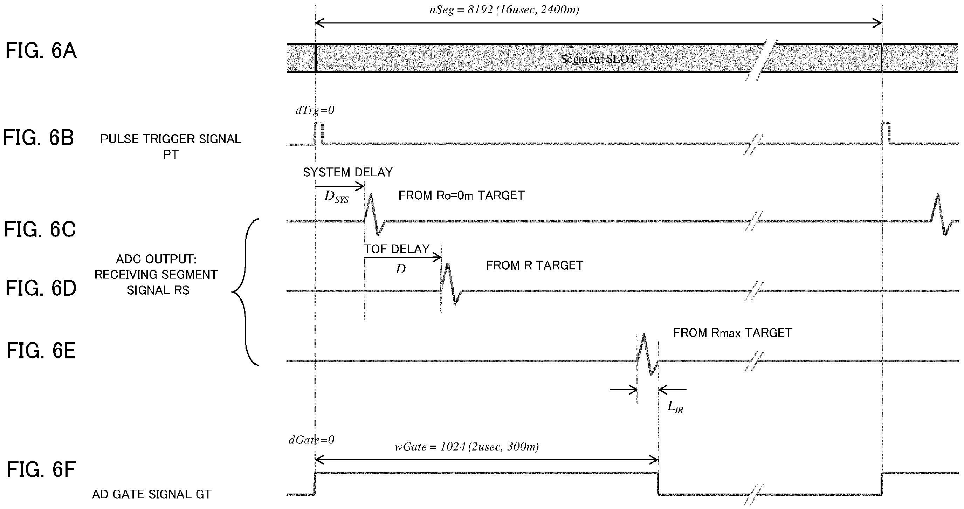

Here, a description will be given of the relation between the ADC output signal and the receiving segment and the settings of the gate position. FIG. 6A illustrates a segment slot. As illustrated in FIG. 6B, the pulse trigger signal PT is asserted with a delay time dTrg from the start point of the segment slot. According to the example illustrated in FIGS. 6A to 6E, the pulse trigger signal PT is asserted at the start point of the segment slot since "dTrg = 0" is satisfied. FIG. 6C illustrates an output signal (i.e., receiving segment signal RS) of the ADC 20 in a case that an object is provided at the scan origin point of a lidar. Namely, FIG. 6C illustrates a receiving segment signal RS in a case that the target distance (moving radius R) is 0 meter. As illustrated, even when the R = 0 m is satisfied, the receiving segment signal RS is monitored in a state that the rise of the receiving segment signal RS lags behind the rise of the pulse trigger signal PT by the system delay $D_{SYS}$. It is noted that examples of the cause of the generation of the system delay $D_{SYS}$ include an electronic delay of the LD driver circuit in the transmitter 30, an optical delay of the transmitting optical system 51, an optical delay of the receiving optical system 52, an electronic delay of the receiver 40 and a conversion delay of the ADC 20.

FIG. 6D illustrates the receiving segment signal RS in a case that the object is situated away by the moving radius R. In this case, compared to FIG. 6C, the delay increases by the round-trip time of the light between the scan origin point and the object. This increase in the delay is so-called "TOF (Time Of Flight)". If the TOF delay corresponds to D samples, the moving radius R can be calculated according to the following equation.

$$R = D\,(c/2)\,/\,Fsmp$$

FIG. 6F illustrates the AD gate signal GT at the time when "dGate = 0" is satisfied. As mentioned above, the gate extractor 14 extracts only the section where the AD gate signal GT is asserted from the output signal of the ADC 20. The DSP 16 to be mentioned later estimates parameter(s) relating to the object only based on the extracted section. Thus, when the TOF delay time is long, the pulse component corresponding to the return light from the object shifts out of the gate, thus leading to inability to correctly estimate the parameter(s). In order to correctly estimate the parameter(s), the TOF delay time is required to satisfy the following equation.

$$D \le D_{MAX} \equiv wGate - D_{SYS} - L_{IR}$$

"$L_{IR}$" stands for the length of the impulse response of the system and "$D_{MAX}$" stands for the maximum TOF delay time which makes the correct parameter estimation possible. FIG. 6E illustrates the receiving segment signal RS at the time when the TOF delay time is equal to the maximum TOF delay time.

Instead of the example illustrated in FIGS. 6A to 6F, the gate delay dGate may be set to the same value as the system delay time. According to the above setting, it is possible to correctly estimate the parameters even when the object is distant.

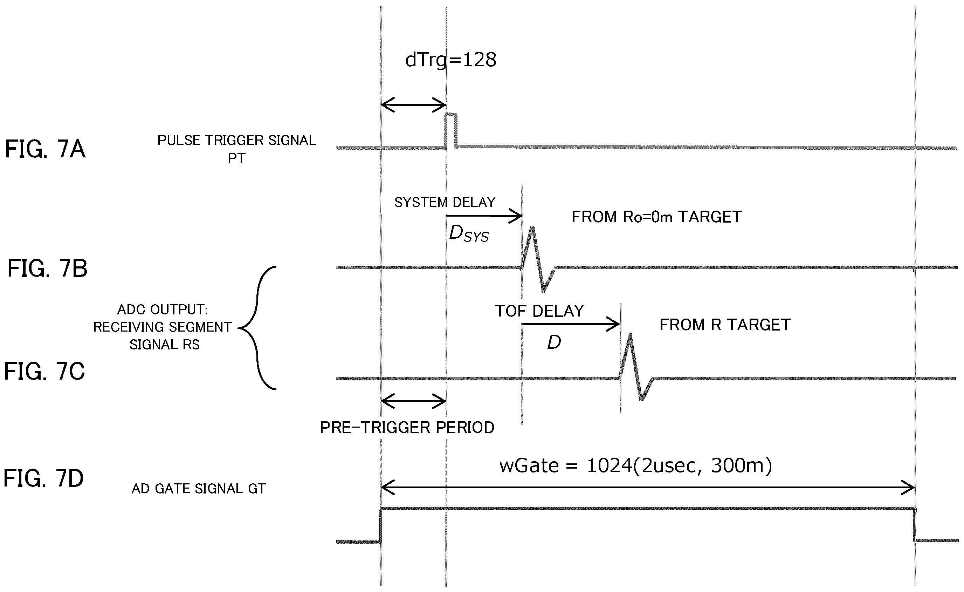

According to the embodiment, by setting the time delay dTrg from the start point of the segment slot to a predetermined value larger than 0, the lidar 1 provides an interval (referred to as "pre-trigger period Tp") from the time when the AD gate signal "GT has just asserted to the time when the pulse trigger signal PT has just asserted. FIGS. 7A to 7D illustrate the pulse trigger signal PT, the receiving segment signal RS and the AD gate signal GT in cases that the time delay dTrg is set to "128" . As described later, on the basis of the receiving segment signal RS obtained during the pre-trigger period Tp, the lidar 1 estimates the amount (referred to as "receiving background light amount") of the background light that is the sun light received by the receiver 40 after the reflection by an object.

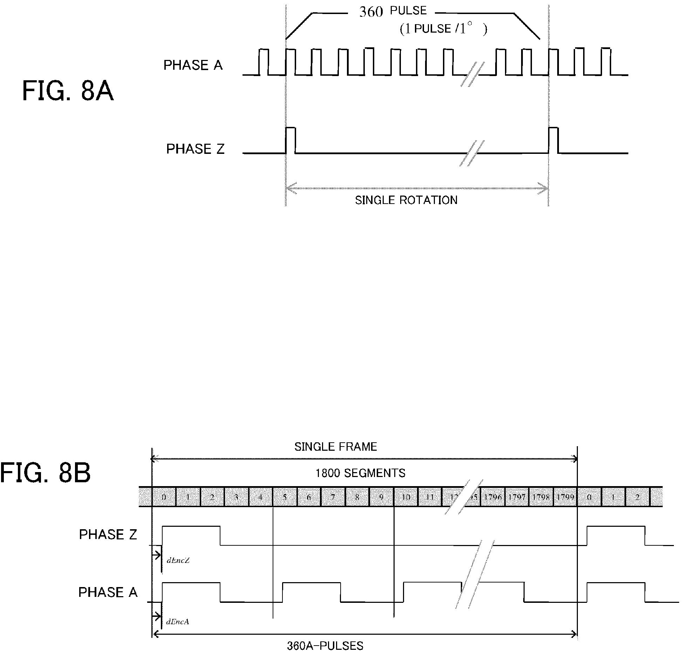

The scan controller 21 monitors the output of the rotary encoder 67 which is provided outside the ASIC 10 and controls the rotation of the motor 54 based thereon. Specifically, the scan controller 21 supplies the torque control signal TC to the motor 54 on the basis of the scan direction information SDI outputted from the rotary encoder 67 (scan direction detector 53) of the scan optical component 50. The rotary encoder 67 according to the embodiment outputs two pulse trains (hereinafter, referred to as "encoder pulses"), the A-phase and the Z-phase. FIG. 8A illustrates the temporal relation between the both pulse trains. As illustrated, as for the A-phase, one pulse is generated and outputted per one degree of rotation of the motor 54. Thus, 360 A-phase encoder pulses are generated and outputted per one rotation of the motor 54. In contrast, as for the Z-phase, one pulse is generated and outputted per one rotation of the motor 54 at a predetermined rotational angle of the motor 54.

The scan controller 21 measures the time of the rise of the encoder pulses to count the counter value of the system clock SCK, and controls the torque of the motor 54 so that the counter value becomes a predetermined value. Namely, the scan controller 21 performs a PLL control of the motor 54 so that the encoder pulses and the segment slot have a desirable temporal relation. FIG. 8B illustrates a temporal relation between the encoder pulses in the stationary state and the segment slot. According to the example illustrated in FIG. 8B, a single frame has 1800 segments and the motor 54 rotates once per single frame.

(6) DSP

DSP 16 sequentially reads out the receiving segment "$y_{frm, seg}$" from the receiving segment memory 15 and processes it, wherein "frm" indicates the index of the frame and "seg" indicates the index of the segment. Hereinafter, these indexes are omitted when the misunderstanding is unlikely to occur. The receiving segment y is a real vector with the vector length wGate and is expressed as the following equation.

$$\mathbf{y} = \{ y_k : k = 0, 1, \cdots, wGate - 1 \}$$

The detailed configuration of the DSP 16 will be described later. The DSP 16 is an example of the "estimation unit", the "control unit" and the "computer" which executes the program according to the present invention.

(7) Dark Reference Reflective Member

The lidar 1 includes the dark reference reflective member 7 which absorbs the outgoing light Lo emitted in a predetermined scan direction. The DSP 16 acquires the receiving segment y corresponding to the light, which is emitted in the predetermined scan direction and incident onto the dark reference reflective member 7, and the DSP 16 uses the receiving segment y as the output signal of the APD 41 to be referred to at the time of estimation of the receiving background light amount.

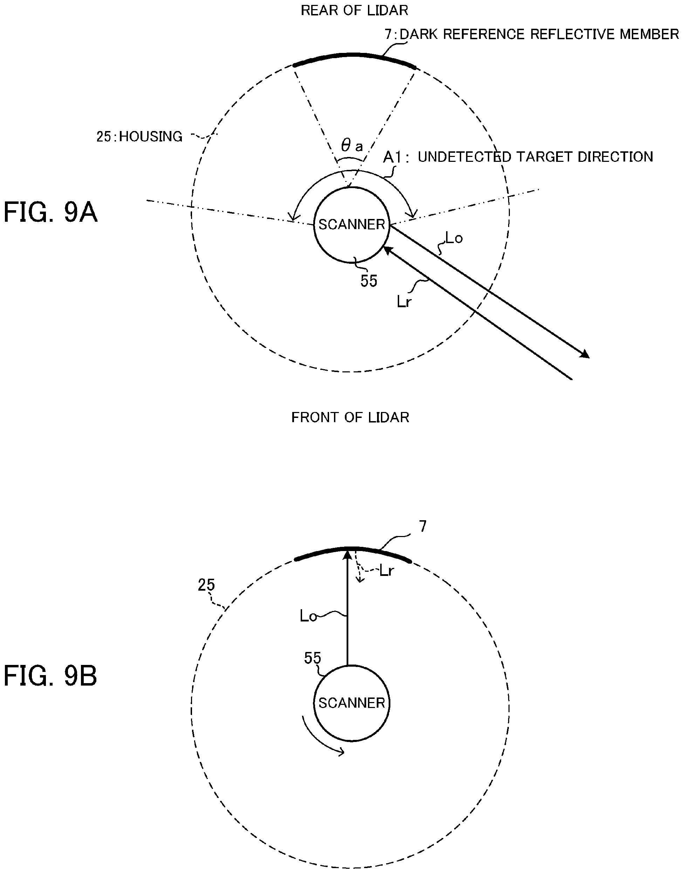

FIG. 9A schematically illustrates the arrangement of the dark reference reflective member 7. In FIG. 9A, the dark reference reflective member 7 is arranged at or near a housing 25 of the lidar 1, wherein the housing 25 houses the scanner 55 and is formed into a nearly cylindrical shape.

The dark reference reflective member 7 is provided on the undetected target direction (see arrow A1) that is the direction other than the target direction of detection of an object by the lidar 1 in the 360-degree irradiation direction of the outgoing light Lo by the scan of the scanner 55. According to the example illustrated in FIG. 9A, the dark reference reflective member 7 is situated on the wall surface of the housing 25, which is irradiated with the outgoing light Lo corresponding to an angle range "θa" (e.g., 60 degree), in the rear of the lidar 1. In this case, for example, the dark reference reflective member 7 is provided on the inside of a transparent cover of the housing 25 which the outgoing light Lo and the return light Lr pass through. In another example, the dark reference reflective member 7 may be a portion of the above transparent cover of the housing 25 processed (e.g., coated with black) to absorb the outgoing light Lo. Hereinafter, for a time span (i.e., one frame period) of a single time scan by the scanner 55, a time period in which the APD 41 receives the outgoing light Lo reflected by the dark reference reflective member 7 is referred to as "dark reference period Td". The dark reference period Td includes multiple segment periods corresponding to scan angles at which the outgoing light Lo is incident on the dark reference reflective member 7. For a single frame period, a time period in which the lidar 1 radiates the outgoing light Lo in the target direction of detection of the object, i.e., a time period in which the dark reference reflective member 7 is not irradiated with the outgoing light Lo is referred to as "target period Tt". Information (e.g., segment index) associated with the above scan angles at which the outgoing light Lo is incident on the dark reference reflective member 7 is stored on the W register in advance so that the DSP 16 can refer to the information.

FIG. 9B illustrates a state that the outgoing light Lo is emitted towards the direction in which the dark reference reflective member 7 is arranged according to the example illustrated in FIG. 9A. When the outgoing light Lo is incident onto the dark reference reflective member 7, the dark reference reflective member 7 absorbs at least a part of the outgoing light Lo. It is noted that, if the dark reference reflective member 7 is made of materials which completely absorbs the outgoing light Lo, the return light Lr is not generated.

For example, the surface of the dark reference reflective member 7 which reflects the outgoing light Lo is formed by such a material that has a very low reflection rate. In another example, the dark reference reflective member 7 has multiple reflection structures and the inside surface (i.e., reflection surface) of each reflection structure is a beam damper with a low reflection rate.

<Control of APD Gain>

Next, a description will be given of approaches for controlling the gain M of the APD 41 based on the receiving background light amount. Schematically, the DSP 16 estimates information associated with the receiving background light amount based on the receiving segment y acquired during the pre-trigger period Tp and then, by referring to a predetermined table based on the estimate, the DSP 16 generates the control signal VC indicative of a voltage to be applied so as to maximize the SNR. Hereinafter, a first embodiment and a second embodiment regarding the DSP 16 capable of performing the above process will be explained below.

(First Embodiment)

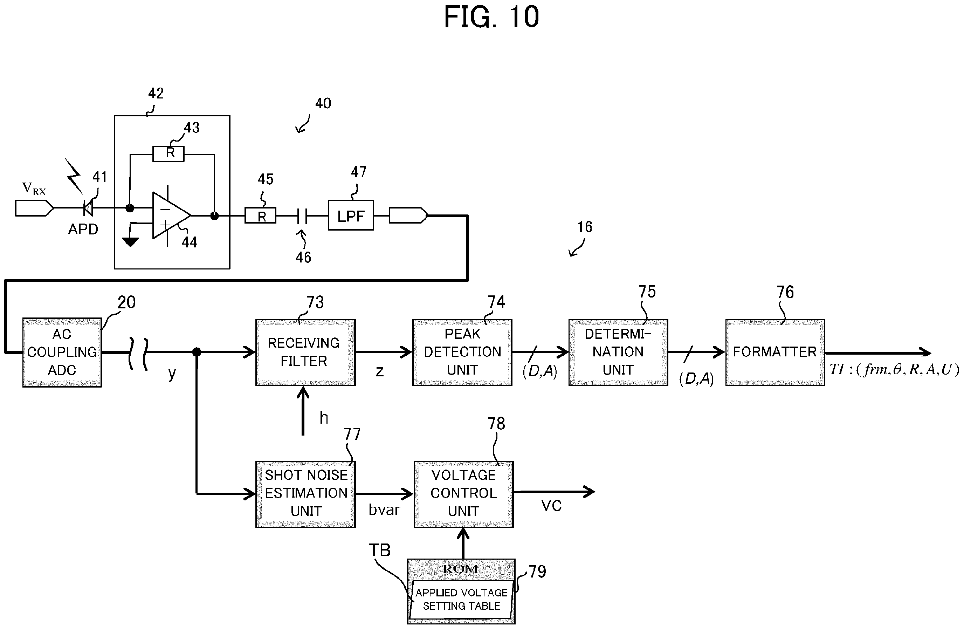

FIG. 10 is a block diagram of the signal processing executed by the DSP 16 according to the first embodiment. As illustrated in FIG. 10, the DSP 16 according to the first embodiment includes a receiving filter 73, a peak detection unit 74, a determination unit 75, a formatter 76, a shot noise estimation unit 77, a voltage control unit 78 and a ROM 79.

The receiver 40 has such a configuration illustrated in FIG. 2B. The output signal of the APD 41 whose direct current (DC) component is omitted by the capacitor 46 is supplied to the ADC 20 (AC coupling ADC) and the receiving segment y based on the signal outputted by the ADC 20 is supplied to the receiving filter 73 and the shot noise estimation unit 77.

The receiving filter 73 convolves (does a circular convolution) the corrected receiving segment y with an impulse response "h" to thereby calculate a filtered segment "z". It is noted that the impulse response h of the receiving filter 73 can be configured through the w register. For example, the impulse response h is determined by the system CPU 5 to increase the SNR at the filter output. It is noted that the circular convolution by the receiving filter 71 may be computed in the frequency domain by use of DFT. This leads to reduction of a great deal of computation. In this case, instead of the impulse response h being configurable through the W register, a frequency response "H", which is calculated in advance through the DFT operation on the impulse response h, may be configurable through the W register.

The peak detection unit 74 detects such a point (i.e., peak point) that the amplitude is maximized and then outputs the delay (delay time) "D" and the amplitude "A" with respect to the peak point. The determination unit 75 selectively transmits only points whose amplitude A is larger than a threshold "tDet". The formatter 76 converts the delay D, the amplitude A, and frame index frm and the segment index seg of the target segment into appropriate forms to output it as the target information TI to the system CPU 5.

The shot noise estimation unit 77 estimates an increase in the shot noise due to the receiving background light amount. The shot noise estimation unit 77 calculates, as the increase in the shot noise due to the receiving background light amount, the difference (referred to as "variance difference bvar") between the variance of the receiving segment y obtained during the pre-trigger period Tp in the dark reference period Td and the variance of the receiving segment y obtained during the pre-trigger period Tp in the target period Tt. Then, the shot noise estimation unit 77 supplies the variance difference bvar to the voltage control unit 78. Since the receiving background light amount varies with respect to each segment, in some embodiments, the shot noise estimation unit 77 calculates the variance difference bvar with respect to each segment.

On the basis of the variance difference bvar, the voltage control unit 78 generates the control signal VC to be sent to the RXHV 18. By referring to the applied voltage setting table TB memorized in the ROM 79, the voltage control unit 78 determines the voltage to be applied to the receiver 40 from the variance difference bvar and generates the control signal VC indicative of the voltage to be applied (applied voltage). A description will be given of the applied voltage setting table TB later.

Next, a detail description will be given of the process executed by the shot noise estimation unit 77.

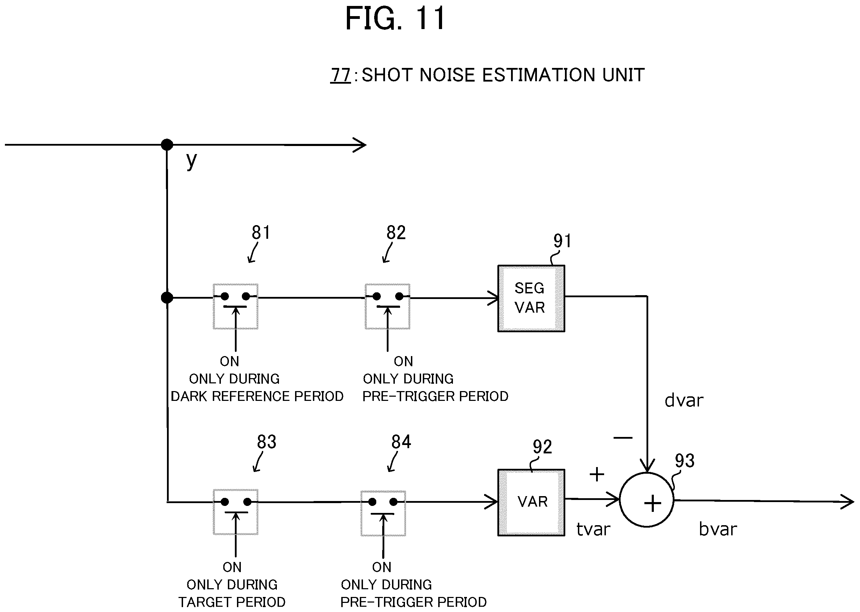

FIG. 11 is a block diagram of the shot noise estimation unit 77. As illustrated in FIG. 11, the shot noise estimation unit 77 includes switches 81 to 84, a first variance calculator 91, a second variance calculator 92 and an operator 93.

The switch 81 is a switch controlled to be turned on only during the dark reference period Td. The switch 82 is a switch controlled to be turned on only during the pre-trigger period Tp. Thus, the receiving segment y generated during the pre-trigger period Tp in the dark reference period Td is supplied to the first variance calculator 91. Then, according to the following equation, the first variance calculator 91 calculates the variance "dvar" for at least one segment in the dark reference period Td when the background light is not substantially received.

$$\mathrm{dvar} = \left( \left( \sum_{k=0}^{k<\mathrm{dTrg}} y(k)^2 \right) \middle/ \mathrm{dTrg} \right) - \left( \left( \sum_{k=0}^{k<\mathrm{dTrg}} y(k) \right) \middle/ \mathrm{dTrg} \right)^2$$

It is noted that the first variance calculator 91 may calculate the variance dvar for multiple segments included in the dark reference period Td and that the first variance calculator 91 may calculate the variance dvar for multiple frames.

The switch 83 is a switch controlled to be turned on only during the target period Tt. The switch 84 is a switch controlled to be turned on only during the pre-trigger period Tp. Thus, the receiving segment y generated during the pre-trigger period Tp in the target period Tt is supplied to the second variance calculator 92. Then, according to the following equation, for each segment, the second variance calculator 92 calculates the variance "tvar" of the receiving segment y in the target period Tt when the return light Lr and the background light are received.

$$\text{tvar} = \left( \left( \sum_{k=0}^{k<dTrg} y(k)^2 \right) \bigg/ dTrg \right) - \left( \left( \sum_{k=0}^{k<dTrg} y(k) \right) \bigg/ dTrg \right)^2$$

The operator 93 calculates the variance difference bvar by subtracting the variance dver from the variance tvar calculated by the second variance calculator 92. It is noted that the variance dvar calculated by the first variance calculator 91 is a variance based on the receiving segment y in which the increase in the shot noise due to the receiving background light amount does not occur and that the variance tvar calculated by the second variance calculator 92 is a variance based on the receiving segment y in which the increase in the shot noise due to the receiving background light amount occur. Accordingly, the operator 93 can suitably calculate the variance difference bvar corresponding to the increase in the shot noise due to the receiving background light amount.

In some embodiments, instead of calculating the variance difference bvar based on the receiving segment y in the pre-trigger period Tp, the shot noise estimation unit 77 may calculate the variance difference bvar based on the receiving segment y during any time period other than the pre-trigger period Tp when the return light Lr does not occur (i.e., a time period when the shot noise due to the signal light does not occur).

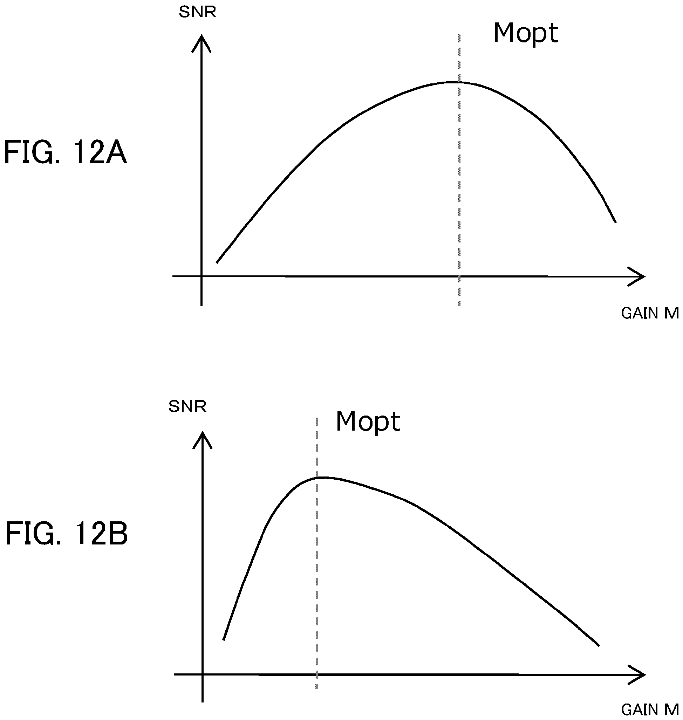

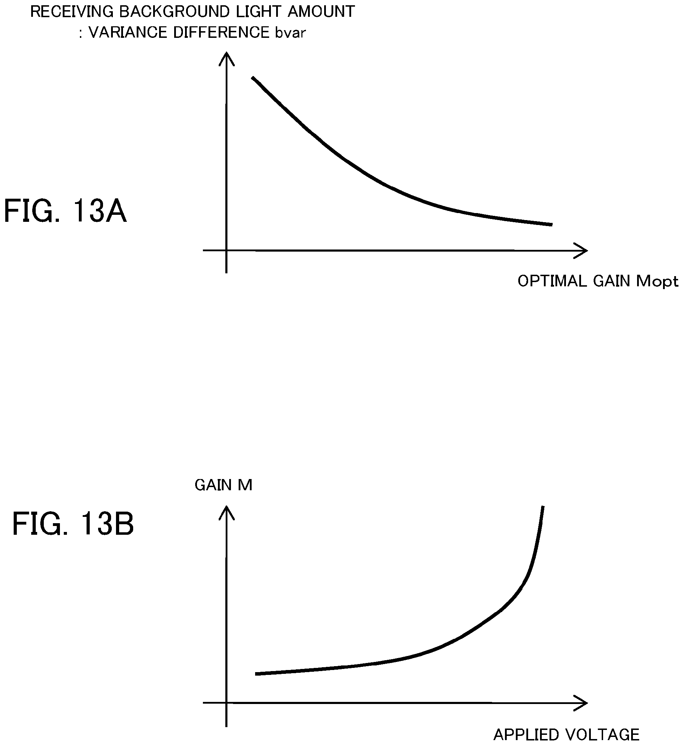

Next, with reference to FIGS. 12A, 12B, 13A and 13B, a description will be given of the applied voltage setting table TB memorized in the ROM 79.

FIG. 12A illustrates a relation between the SNR and the gain M in cases that the receiving background light amount is relatively small and FIG. 12B illustrates a relation between the SNR and the gain M in cases that the receiving background light amount is relatively large. As illustrated in FIGS. 12A and 12B, with increasing degree of the gain M, the SNR firstly increases and reaches the peak and decreases after reaching the peak. Besides, the relation between the SNR and the gain M depends on the receiving background light amount. Such a gain M (referred to as "optimal gainMopt") of the APD 41 that the SNR is maximized varies depending on the receiving background light amount. In consideration of these matters, the lidar 1 refers to the applied voltage setting table TB memorized in the ROM 79 in advance. Thereby, the lidar 1 suitably obtains, from the receiving background light amount, the voltage to be applied to the APD 41 in order to obtain the gain M of the APD 41 equivalent to the optimal gain Mopt.

FIGS. 13A and 13B illustrate graphs, which is memorized by the lidar 1 as the applied voltage setting table TB, indicative of the relation between the receiving background light amount and the voltage to be applied to the APD 41. Specifically, FIG. 13A schematically illustrates a graph indicative of a relation between the receiving background light amount corresponding to the variance difference bvar and the optimal gain Mopt and FIG. 13B schematically illustrates a graph indicative of a relation between the gain M of the APD 41 and the voltage (applied voltage) to be applied to the APD 41.

By referring to the applied voltage setting table TB which defines the relations indicated by FIGS. 13A and 13B, the voltage control unit 78 generates, by use of the variance difference bvar indicative of the receiving background light amount, the control signal VC which indicates the voltage to be applied to the receiver 40. Specifically, on the basis of the relation indicated by FIG. 13A, the voltage control unit 78 identifies the gain M corresponding to the optimal gainMopt from the variance difference bvar indicative of the receiving background light amount. Then, on the basis of the relation indicated by FIG. 13B, the voltage control unit 78 identifies the voltage to be applied to the APD 41 in order to obtain the identified gain M.

It is noted that two tables corresponding to FIGS. 13A and 13B respectively may be memorized as the applied voltage setting table (s) TB in the ROM 79 or a single table which defines the voltage to be applied to the APD 41 to obtain the optimal gain Mopt in accordance with the estimated receiving background light amount may be memorized as the applied voltage setting table TB in the ROM 79. For example, the measurement of the applied voltage setting table TB is conducted in the developing process or in the manufacturing process of the lidar 1. When the measurement is conducted in the developing process, the representative value of the measured values for multiple lidars 1 is memorized in the applied voltage setting table TB. When the measurement is conducted in the manufacturing process, each measured value for each lidar 1 is memorized in the applied voltage setting table TB of each lidar 1.

It is also noted that the voltage control unit 78 may determine the approach for controlling the gain M of the APD 41 in accordance with the degree of the variation of the relative position between the lidar 1 and the peripheral environment. For example, in cases that both of the lidar 1 and the peripheral environment do not move, i.e., the positional relation between the lidar 1 and the peripheral environment does not change, the voltage control unit 78 adjusts the voltage to be applied to the APD 41 so that the gain M of the APD 41 becomes the optimal gain Mopt. Specifically, on the basis of the receiving background light amount estimated by use of the receiving segment y extracted in the corresponding segment of the proceeding frame, the voltage control unit 78 generates the control signal VC indicative of the voltage to be applied to the APD 41 with respect to each segment and supplies the control signal VC to the RXHV 18. In a similar way, in cases that the peripheral environment does not move (remain still) and the moving speed of the lidar 1 is low, i.e., the positional relation between the lidar 1 and the peripheral environment does not change rapidly, the voltage control unit 78 controls the gain M of the APD 41 with respect to each segment as with the cases that the positional relation between the lidar 1 and the peripheral environment does not change. In this case, on the basis of the receiving background light amount estimated by use of the receiving segment y extracted in the corresponding segment of the proceeding frame, the voltage control unit 78 adjusts the voltage applied to the APD 41 with respect to each segment so that the gain M of the APD 41 becomes the optimal gain Mopt.

In contrast, in cases that the positional relation between the lidar 1 and the peripheral environment rapidly changes, the voltage control unit 78 does not control the gain M of the APD 41 with respect to every individual segment. In this case, according to a first example, on the basis of the receiving background light amount averaged per frame, the voltage control unit 78 controls the gain M of the APD 41 with respect to each frame. In this case, with respect to each frame, the voltage control unit 78 calculates the mean value of the estimated variance difference bvar calculated at each segment and then determines the voltage to be applied to the APD 41 based on the calculated mean value with reference to the applied voltage setting table TB. According to a second example, on the basis of the maximum value or the minimum value of the receiving background light amount estimated per frame, the voltage control unit 78 controls the gain M of the APD 41 with respect to each frame. According to a third example, on the basis of the mean value, the maximum value or the minimum value of the receiving background light amount estimated per frame, the voltage control unit 78 controls the gain M of the APD 41 with respect to each frame. According to a fourth example, the voltage control unit 78 averages, in the frame direction (i.e., among different frame indexes) through an IIR filter and the like, the mean values of the receiving background light amount estimated through multiple frames and on the basis of the averaged mean values, the voltage control unit 78 controls the gain M of the APD 41 with respect to each frame.

In these cases, on the basis of the output of sensor(s) which detect the moving velocity, the lidar 1 may determine whether or not the control of the gain M of the APD 41 per segment should be performed. For example, at the time when the moving velocity detected by the above sensor(s) is equal to or smaller than a predetermined velocity, the lidar 1 controls the gain M of the APD 41 with respect to each segment. In contrast, at the time when the moving velocity detected by the above sensor (s) is larger than a predetermined velocity, the lidar 1 controls the gain M of the APD 41 with respect to each frame . In the same way, regarding the second embodiment to be mentioned later, the voltage control unit 78 may also determine the approach for controlling the gain M of the APD 41 in accordance with the degree of the variation of the relative position between the lidar 1 and the peripheral environment.

(Second Embodiment)

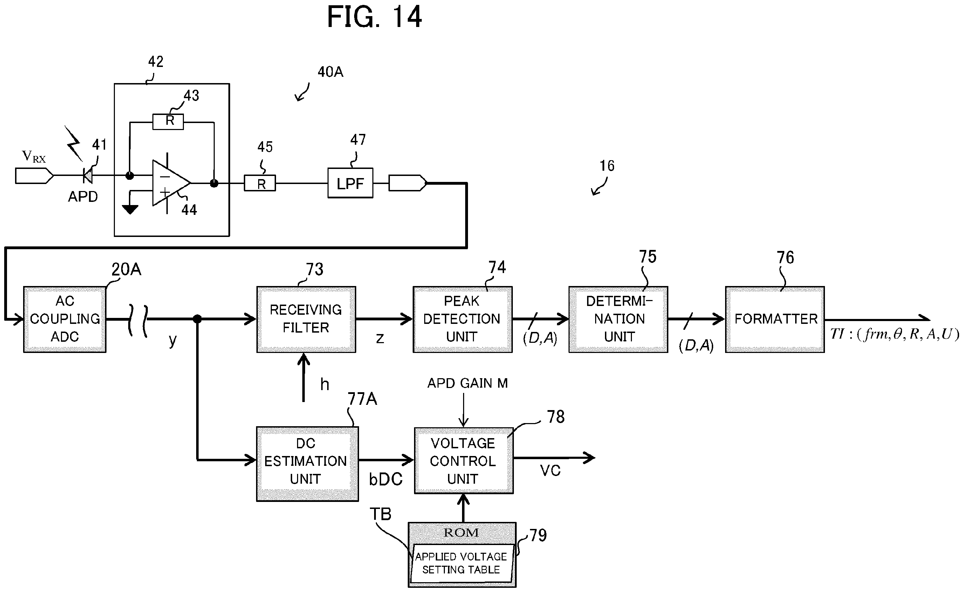

FIG. 14 is a block diagram of the signal processing executed by the DSP 16 according to the second embodiment. As illustrated in FIG. 14, the DSP 16 according to the second embodiment includes the receiving filter 73, the peak detection unit 74, the determination unit 75, the formatter 76, a DC estimation unit 77A, the voltage control unit 78 and the ROM 79. Hereinafter, the same reference numbers as the first embodiment are allocated to the same elements as the first embodiment and the explanation thereof will be omitted.

A receiver 40A has such a configuration in which the capacitor 46 is omitted from the receiver 40 illustrated in FIG. 2B and FIG. 10. According to the configuration, the output signal of the APD 41 with the direct current (DC) component is supplied from the receiver 40A to the ADC 20A (DC coupling ADC) and the receiving segment y based on the output signal of the ADC 20A is supplied to the receiving filter 73 and the DC estimation unit 77A.

The DC estimation unit 77A calculates the direct current component (referred to as "estimated receiving background light amount bDc") of the receiving background light amount and then supplies the estimated receiving background light amount bDc to the voltage control unit 78.

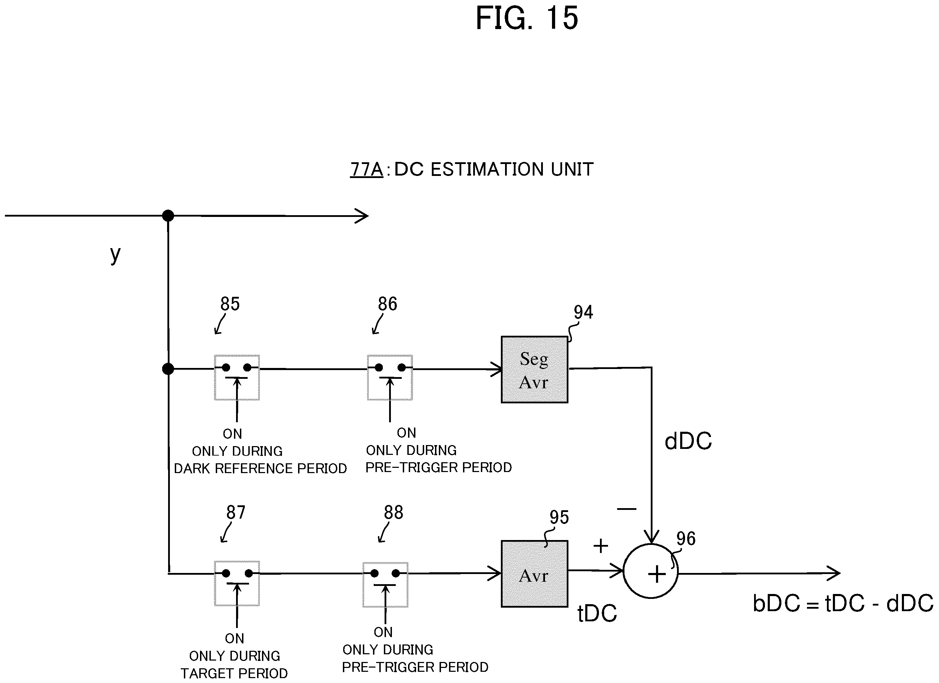

FIG. 15 is a block diagram of the DC estimation unit 77A. As illustrated in FIG. 15, the DC estimation unit 77A includes switches 85 to 88, a first average calculator 94, a second average calculator 95 and an operator 96.

The switch 85 is a switch controlled to be turned on only during the dark reference period Td and the switch 86 is a switch controlled to be turned on only during the pre-trigger period Tp. Thus, the first average calculator 94 is supplied with the receiving segment y generated during the pre-trigger period Tp in the dark reference period Td. Then, for the receiving segment y generated in at least one segment of the pre-trigger period Tp in the dark reference period Td, the first average calculator 94 calculates the average "dDC" corresponding to the direct current component of the receiving segment y according to the following equation.

$$dDC = \left( \left( \sum_{k=0}^{k<dTrg} y(k)^2 \right) \Big/ dTrg \right)$$

The switch 87 is a switch controlled to be turned on only during the target period Tt and the switch 88 is a switch controlled to be turned on only during the pre-trigger period Tp. Thus, the second average calculator 95 is supplied with the receiving segment y generated during the pre-trigger period Tp in the target period Tt. Thus, with respect to each segment, the second average calculator 95 calculates the average "tDC" of the direct current component of the receiving segment y generated during the pre-trigger period Tp in the target period Tt according to the following equation.

$$tDC = \left( \left( \sum_{k=0}^{k<dTrg} y(k)^2 \right) \Big/ dTrg \right)$$

The operator 96 calculates the estimated receiving background light amount bDc by subtracting the average dDC from the average tDC calculated by the second average calculator 95. Here, the average dDc calculated by the first average calculator 94 is the direct current component calculated based on the receiving segment y which is not affected by the receiving background light amount whereas the average tDc calculated by the second average calculator 95 is the direct current component calculated based on the receiving segment y which is affected by the receiving background light amount. Thus, on the basis of the average dDc and the average tDc, the operator 93 can suitably calculate the estimated receiving background light amount bDc corresponding to the receiving background light amount which the receiver 40A receives.

A description will be given of the DSP 16 according to the second embodiment with reference to FIG. 14 again. The voltage control unit 78 determines the voltage to be applied to the APD 41 based on: the estimated receiving background light amount bDc supplied from the DC estimation unit 77A; the gain M of the APD 41 at the time of generating the receiving segment y which is used for calculation of the estimated receiving background light amount bDc; and the applied voltage setting table TB memorized in the ROM 79. Then, the voltage control unit 78 generates the control signal VC indicative of the voltage to be applied to the APD 41. Here, the estimated receiving background light amount bDc depends on the gain M of the APD 41 at the time of the generation of the receiving segment y which is used for the estimation. Thus, the voltage control unit 78 acquires the above gain M of the APD 41 and determines the voltage to be applied to the APD 41 in accordance with the acquired gain M of the APD 41. In this case, for example, the voltage control unit 78 normalizes the estimated receiving background light amount bDc by using the acquired gain M of the APD 41 and determines, with reference to the applied voltage setting table TB, the voltage to be applied to the APD 41 based on the estimated receiving background light amount bDc after the normalization.

As described above, the lidar 1 is provided with the APD 41 and the DSP 16. The APD 41 receives the return light Lr that is the outgoing light Lo radiated by the scanner 55 and thereafter reflected by an object. The DSP 16 includes the shot noise estimation unit 77 or the DC estimation unit 77A and the voltage control unit 78. The shot noise estimation unit 77 or the DC estimation unit 77A estimates, on the basis of the output signal from the APD 41, information associated with receiving background light amount that is the sun light reflected by the object and thereafter received by the APD 41. The voltage control unit 78 determines, on the basis of the estimated receiving background light amount, the voltage to be applied to the APD 41 in order to control the gain M of the APD 41. Thereby, the lidar 1 can suitably adjust the gain M of the APD 41 so that the SNR is maximized.

<Modifications>

The configuration for estimating the receiving background light amount is not limited to the configuration illustrated in FIG. 10 and FIG. 14. Instead, the lidar 1 may have another background light monitoring system other than the receiver 40 that functions as the main receiving system.

In this case, according to a first example, the other background light monitoring system other than the receiver 40 has another APD and scanning mechanism whose scan timing is earlier than the scan timing by the APD 41 of the receiver 40 that functions as the main receiving system, and the lidar 1 estimates the receiving background light amount based on the output signal from the other APD. According to a second example, the lidar 1 is equipped with a wide-angle camera and estimates the receiving background light amount based on the image outputted by the camera. In this case, the lidar 1 converts the information (e.g., brightness) obtained with respect to each pixel in the image outputted by the camera into the receiving background light amount with respect to each segment. In this way, the lidar 1 can suitably estimate the receiving background light amount based on the other background light monitoring system other than the receiver 40.

BRIEF DESCRIPTION OF REFERENCE NUMBERS

[0096]

1    Lidar
5    System CPU
7    Dark reference reflective member
10   ASIC
30   Transmitter
40   Receiver
50   Scan optical component

**Claims**

1. A receiving device comprising:

   a receiving unit which receives a reflected electromagnetic ray that is an electromagnetic ray reflected by an object, the electromagnetic ray being radiated from an irradiation unit;
   an estimation unit configured to estimate a background light amount based on an output signal from the receiving unit; and
   a control unit configured to control the receiving unit based on information associated with the estimated background light amount.

2. The receiving device according to claim 1,
   wherein the receiving unit includes a photodiode, and
   wherein the control unit controls a gain of the photodiode .

3. The receiving device according to 1 or 2,
   wherein the control unit determines a voltage to be applied to the receiving unit by referring to a table for determining, from the information associated with the background light amount, the voltage which makes a signal-to-noise ratio of the receiving unit a predetermined value.

4. The receiving device according to 1 or 2,
   wherein the table includes:

   a first table for determining, from the information associated with the background light amount, a gain of the receiving unit which makes the signal-to-noise ratio the predetermined value; and
   a second table for determining the voltage to be applied to the receiving unit to obtain the gain of the receiving unit.

5. The receiving device according to any one of claims 1 to 4,
   wherein the estimation unit estimates the background light amount based on the output signal from the receiving unit, the output signal being generated before a time period when the reflected electromagnetic ray is received.

6. The receiving device according to any one of claims 1 to 5,
   wherein the estimation unit estimates the background light amount based on
   the output signal outputted at a first timing from the receiving unit and
   the output signal outputted at a second timing from the receiving unit.

7. The receiving device according to any one of claims 1 to 5,
   wherein the estimation unit estimates the background light amount with respect to each segment period in which the output signal corresponding to each radiating direction by the irradiation unit is obtained from the receiving unit, and
   wherein the control unit controls a gain of the receiving unit with respect to each segment period.

8. The receiving device according to any one of claims 1 to 7,

wherein the estimation unit estimates, as the information associated with the background light amount, an increase in a shot noise generated due to the background light amount, and
wherein the control unit controls the receiving unit based on the increase in the shot noise.

9.  The receiving device according to any one of claims 1 to 8,
    wherein the estimate unit estimates an increase in a direct current component generated due to the background light amount, and
    wherein the control unit controls the receiving unit based on:

    the increase in the direct current component; and
    a gain of the receiving unit at a time when the output signal used for the estimation of the increase in the direct current component is outputted.

10. A control method executed by a receiving device, the receiving device including a receiving unit which receives a reflected electromagnetic ray that is an electromagnetic ray reflected by an object, the electromagnetic ray being radiated from an irradiation unit, the control method comprising:

    an estimation process to estimate a background light amount based on an output signal from the receiving unit; and
    a control process to control the receiving unit based on information associated with the estimated background light amount.

11. A program executed by a computer of a receiving device, the receiving device including a receiving unit which receives a reflected electromagnetic ray that is an electromagnetic ray reflected by an object, the electromagnetic ray being radiated from an irradiation unit, the program making the computer function as :

    an estimation unit configured to estimate a background light amount based on an output signal from the receiving unit; and
    a control unit configured to control the receiving unit based on information associated with the estimated background light amount.

12. A storage medium storing the program according to claim 11.

# FIG. 1

EP 3 647 812 A1

FIG. 2A

FIG. 2B

50

FIG. 3

FIG. 4

| NAME | DEFINITION | FORMAT | DEFAULT | UNIT |
|---|---|---|---|---|
| *nSeg* | SEGMENT CYCLE | unsigned | 8192 | Tsys |
| *dTrg* | TRIGGER DELAY | signed | 0 | Tsys |
| *wTrg* | TRIGGER WIDTH | unsigned | 64 | Tsys |
| *dGate* | GATE DELAY | signed | 0 | Tsys |
| *wGate* | GATE WIDTH | unsigned | 1024 | Tsys |

# FIG. 5

TIME

Segment SLOT (n-1) | Segment SLOT (n) | Segment SLOT (n+1)

$nSeg$ [sysclk]

$nSeg$

Segment SLOT

PULSE TRIGGER SIGNAL
PT

$dTrg$

$wTrg$

AD GATE SIGNAL
GT

$dGate$

$wGate$

EP 3 647 812 A1

FIG. 6A

FIG. 6B  PULSE TRIGGER SIGNAL
PT

FIG. 6C

FIG. 6D  ADC OUTPUT:
RECEIVING SEGMENT
SIGNAL RS

FIG. 6E

FIG. 6F

AD GATE SIGNAL GT

$nSeg = 8192\ (16usec,\ 2400m)$

Segment SLOT

$dTrg=0$

SYSTEM DELAY

$D_{SYS}$  FROM Ro=0m TARGET

TOF DELAY

$D$  FROM R TARGET

FROM Rmax TARGET

$L_{IR}$

$dGate=0$  $wGate = 1024\ (2usec,\ 300m)$

EP 3 647 812 A1

FIG. 7A PULSE TRIGGER SIGNAL PT

dTrg=128

FIG. 7B ADC OUTPUT: RECEIVING SEGMENT SIGNAL RS

SYSTEM DELAY $D_{SYS}$

FROM Ro=0m TARGET

FIG. 7C

TOF DELAY $D$

FROM R TARGET

PRE-TRIGGER PERIOD

FIG. 7D AD GATE SIGNAL GT

wGate = 1024(2usec, 300m)

EP 3 647 812 A1

## FIG. 8A

PHASE A

360 PULSE
(1 PULSE /1°)

PHASE Z

SINGLE ROTATION

## FIG. 8B

SINGLE FRAME

1800 SEGMENTS

| 0 | 1 | 2 | 3 | 4 | 5 | 6 | 7 | 8 | 9 | 10 | 11 | 1? | )5 | 1796 | 1797 | 1798 | 1799 | 0 | 1 | 2 |

PHASE Z

dEncZ

PHASE A

dEncA

360A-PULSES

EP 3 647 812 A1

FIG. 9A

REAR OF LIDAR

7: DARK REFERENCE REFLECTIVE MEMBER

25: HOUSING

$\theta a$

A1: UNDETECTED TARGET DIRECTION

SCANNER

Lo

55

Lr

FRONT OF LIDAR

FIG. 9B

7

25

Lr

Lo

55

SCANNER

22

# FIG. 10

# FIG. 11

<u>77</u>:SHOT NOISE ESTIMATION UNIT

y

81

82

91

SEG VAR

ON
ONLY DURING
DARK REFERENCE PERIOD

ON
ONLY DURING
PRE-TRIGGER PERIOD

dvar

83

84

92

VAR

ON
ONLY DURING
TARGET PERIOD

ON
ONLY DURING
PRE-TRIGGER PERIOD

+

tvar

−

93

+

bvar

EP 3 647 812 A1

SNR

Mopt

FIG. 12A

GAIN M

SNR

Mopt

FIG. 12B

GAIN M

RECEIVING BACKGROUND LIGHT AMOUNT
: VARIANCE DIFFERENCE bvar

FIG. 13A

OPTIMAL GAIN Mopt

GAIN M

FIG. 13B

APPLIED VOLTAGE

## FIG. 14

EP 3 647 812 A1

# FIG. 15

<u>77A</u> : DC ESTIMATION UNIT

y

85

86

94

Seg Avr

ON
ONLY DURING
DARK REFERENCE PERIOD

ON
ONLY DURING
PRE-TRIGGER PERIOD

dDC

87

88

95

Avr

ON
ONLY DURING
TARGET PERIOD

ON
ONLY DURING
PRE-TRIGGER PERIOD

tDC

−

+

96

+

bDC = tDC - dDC

## INTERNATIONAL SEARCH REPORT

| International application No. |
|---|
| PCT/JP2018/024052 |

| A. CLASSIFICATION OF SUBJECT MATTER |
|---|
| Int.Cl. G01S7/489(2006.01)i, G01S7/487(2006.01)i |

According to International Patent Classification (IPC) or to both national classification and IPC

| B. FIELDS SEARCHED |
|---|
| Minimum documentation searched (classification system followed by classification symbols) |
| Int.Cl.   G01S7/48-7/51,  G01S17/00-17/95,  G01C3/06,  G01B11/00-11/30, H03F3/08, H01L31/10 |

| Documentation searched other than minimum documentation to the extent that such documents are included in the fields searched |  |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X<br>Y | JP 3-296309 A (MITSUBISHI ELECTRIC CORP.) 27 December 1991, page 2, upper left column, line 10 to page 3, lower left column, bottom line, fig. 1 (Family: none) | 1-2, 8, 10<br>3-7, 9, 11-12 |
| Y | WO 2008/099507 A1 (FUJITSU OPTICAL COMPONENTS LTD.) 21 August 2008, paragraph [0039] & US 2009/0238582 A1, paragraph [0082] & US 2013/0071106 A1 & EP 2120372 A1 | 3-7, 9 |

☒ Further documents are listed in the continuation of Box C.　　☐　See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 September 2018 (18.09.2018) | 02 October 2018 (02.10.2018) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**

International application No.

PCT/JP2018/024052

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-324909 A (NIKON CORP.) 08 November 2002, paragraphs [0015], [0017]-[0025], fig. 1-2 & US 2004/0070748 A1, paragraphs [0078], [0137]-[0145], fig. 10-11 & US 2005/0231709 A1 & WO 2002/088772 A1 & EP 1382979 A1 & CN 1503914 A | 5-7, 9, 11-12 |
| Y | CD-ROM of the specification and drawings annexed to the request of Japanese Utility Model Application No. 070006/1991 (Laid-open No. 023175/1993) (MITSUBISHI HEAVY INDUSTRIES, LTD.) 26 March 1993, paragraphs [0007]-[0012], fig. 1 (Family: none) | 6, 9 |
| Y | JP 2016-070874 A (FUJITSU LTD.) 09 May 2016, claims 1-2, paragraphs [0009]-[0021], fig. 1-4 (Family: none) | 7, 9 |
| Y | JP 5-308232 A (SHARP CORP.) 19 November 1993, paragraphs [0003], [0009]-[0010], fig. 5, 1-2 (Family: none) | 9 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008286669 A